# FASCICULE DE BREVET EUROPEEN

(11) **EP 4 391 081 B1**
(45) Date de publication et mention de la délivrance du brevet: **21.05.2025**
(21) Numéro de dépôt: 23218845.8
(22) Date de dépôt: 20.12.2023
(51) Int. Cl.: H10B 12/00, H10B 51/30, H10D 30/47, H10D 30/67, H10D 64/01, H10D 64/23, H10D 99/00, H10D 62/10, H10D 62/80, H10D 30/01, H10D 64/62, B82Y 10/00

(54) **DISPOSITIF MICROÉLECTRONIQUE COMPRENANT D'IMPORTANTES SURFACES DE CONTACT ENTRE LE CANAL DE CONDUCTION ET LES RÉGIONS DE SOURCE ET DRAIN**
MIKROELEKTRONISCHE VORRICHTUNG MIT KONTAKTFLÄCHEN ZWISCHEN LEITUNGSKANAL UND SOURCE- UND DRAIN-BEREICHEN
MICROELECTRONIC DEVICE INCLUDING LARGE CONTACT SURFACES BETWEEN THE CONDUCTION CHANNEL AND THE SOURCE AND DRAIN REGIONS

(30) Priorité: 22.12.2022 FR 2214254; 22.12.2022 FR 2214255
(43) Date de publication de la demande: 26.06.2024
(73) Titulaire: Commissariat à l'Energie Atomique et aux Energies Alternatives, 75015 Paris (FR)
(72) Inventeur: BARRAUD, Sylvain, 38054 Grenoble Cedex 09 (FR); COQUAND, Rémi, 38054 Grenoble Cedex 09 (FR); REBOH, Shay, 38054 Grenoble Cedex 09 (FR)
(74) Mandataire: Brevalex

(56) Documents cités:
- EP-A1- 4 020 586
- US-A1- 2021 408 227
- US-B1- 10 388 732

## Description

### DOMAINE TECHNIQUE

L'invention concerne le domaine des dispositifs microélectroniques appliqués aux technologies CMOS avancées. L'invention porte notamment sur des dispositifs microélectroniques de type FET (« Field-Effect Transistor » en anglais, ou transistor à effet de champ), notamment à nanofils ou « nano-sheets » (nano-feuilles) empilés, ou CFET (« Complementary Field-Effect Transistor » en anglais, ou transistor à effet de champ complémentaire), en particulier à base de matériaux bidimensionnels, ou matériaux 2D, ou oxydes semiconducteurs, et la réalisation de tels dispositifs microélectroniques. L'invention concerne également le domaine des dispositifs mémoires de type FeFET (« Ferroelectric Field Effect Transistor » en anglais, ou transistor ferroélectrique à effet de champ), et la réalisation de tels dispositifs mémoires.

### État de la technique antérieure

La miniaturisation de l'électronique est en constante augmentation, mais l'industrie approche désormais de la limite d'échelle pour les matériaux classiques tels que le silicium. Dernièrement, les matériaux 2D sont apparus comme des candidats prometteurs pour une utilisation dans les dispositifs électroniques et optoélectroniques miniaturisés en raison de leurs propriétés uniques et de la très faible épaisseur des couches de ces matériaux qui peuvent être constitués d'une seule couche d'atomes ou de molécules.

Le document de K. P. O'Brien et al., "Advancing 2D Monolayer CMOS Through Contact, Channel and Interface Engineering," 2021 IEEE International Electron Devices Meeting (IEDM), 2021, pp. 7.1.1-7.1.4, propose de réaliser un transistor MOSFET en intégrant une couche de MoS₂ pour former le canal de conduction. Cette couche est connectée à deux régions de source et drain métalliques à base d'or, de palladium, de TiN, de tungstène ou encore de nickel. La grille arrière est formée par une couche de silicium dopé positionnée en face arrière sous une couche de diélectrique à base de SiO₂, HfO₂ ou d'Al₂O₃.

Afin de s'affranchir des contraintes liées au dépôt des matériaux métalliques des régions de source et de drain sur le matériau 2D, il est possible de former ces régions non pas sur la face supérieure de la couche de matériau 2D, mais contre les flancs de la couche de matériau 2D. Cette configuration, appelée « side contact », est toutefois problématique car la surface de contact entre la couche de matériau 2D et les régions de source et de drain est faible, ce qui engendre d'importantes résistances de contact aux interfaces entre la couche de matériau 2D et les régions de source et de drain.

Le document US 2022/045176 A1 décrit plusieurs procédés de réalisation de transistors FET de type « gate-last », dans lesquels des portions de silicium servent de support pour le dépôt d'une couche de matériau 2D. Outre les inconvénients liés au fait que les transistors réalisés ont des interfaces canal / source-drain de type « side contact », les portions de silicium utilisées pour déposer le matériau 2D forment une barrière de potentiel à l'interface avec le matériau 2D, ce qui n'est pas favorable car une partie du transport des charges peut s'effectuer dans ces portions de silicium et non dans le matériau 2D. Le document US 2019/123183 D1 présente un dispositif microélectronique avec une couche de semi-conducteur comprenant plusieurs zones superposées les unes au-dessus des autres et formant un canal de conduction électrique du dispositif microélectronique.

Le document US 10 388 732 B1 divulgue un transistor à effet de champ comprenant un matériau semi-conducteur bidimensionnel formant des couches de canal entourées par des sections d'une structure de grille comprenant une couche diélectrique de grille. De plus, ledit matériau semi-conducteur est en contact avec des espaceurs diélectriques de grille, lesquels sont positionnés entre ledit matériau semi-conducteur et ladite couche diélectrique de grille.

### EXPOSÉ DE L'INVENTION

Un but de la présente invention est de proposer un dispositif microélectronique dont la structure soit compatible avec tout type de matériau semi-conducteur dont les matériaux 2D, et ne présentant pas les inconvénients d'une configuration « side contact ».

Pour cela, la présente invention propose un dispositif microélectronique comprenant au moins :
- un substrat ;
- une couche de semi-conducteur comprenant plusieurs premières zones superposées les unes au-dessus des autres et formant un canal de conduction électrique du dispositif microélectronique ;
- une grille de commande électrostatique ;
- une couche de diélectrique de grille ou une couche mémoire ferroélectrique, telles que des parties de la couche de diélectrique de grille ou de la couche mémoire ferroélectrique soient chacune disposées entre une partie de la grille de commande électrostatique et l'une des premières zones de la couche de semi-conducteur ;
- des espaceurs diélectriques disposés contre des flancs de la grille de commande électrostatique ;
- des régions de source / drain couplées électriquement aux premières zones de la couche de semi-conducteur par des deuxièmes zones de la couche de semi-conducteur, les deuxièmes zones de la couche de semi-conducteur s'étendant entre les régions de source / drain et les espaceurs diélectriques ;
et dans lequel les deuxièmes zones de la couche de semi-conducteur ne sont pas disposées directement contre la grille de commande électrostatique et forment, avec les premières zones, une couche continue.

Les deuxièmes zones de la couche de semi-conducteur sont en contact avec la couche de diélectrique ou de mémoire ferroélectrique. Avantageusement, une face de la couche de semi-conducteur est entièrement en contact avec la couche de diélectrique ou de mémoire ferroélectrique.

La couche de semi-conducteur, en particulier en matériau 2D, a typiquement une épaisseur homogène, cette couche étant formée sur un seul matériau.

Le dispositif microélectronique proposé se base sur une architecture ne comportant pas d'interface de type « side contact » entre le canal et les régions de source / drain grâce aux deuxièmes zones de la couche de semi-conducteur réalisant le couplage électrique entre le canal formé par les premières zones de la couche de semi-conducteur et les régions de source / drain. Ces deuxièmes zones de la couche de semi-conducteur, qui s'étendent contre au moins une partie des parois latérales, ou flancs, des régions de source / drain, forment une grande surface de contact avec les régions de source / drain, ce qui permet de réduire les résistances de contact de ces régions de source / drain. Ainsi, le courant électrique circulant dans le canal n'est pas réduit à cause de ces résistances de contact, ce qui ne réduit pas les performances du dispositif.

De plus, avec l'architecture proposée, la couche de semi-conducteur peut être réalisée après la grille de commande électrostatique et juste avant la réalisation des régions de source / drain, ou juste avant le dépôt métallique des régions de source / drain. Ainsi, la couche de semi-conducteur dont les premières zones sont destinées à former le canal de conduction n'est pas détériorée par les étapes liées à la réalisation de la grille de commande électrostatique ou la réalisation des espaceurs internes de la structure GAA. Cela est particulièrement avantageux lorsque la couche de semi-conducteur comporte un matériau 2D.

En outre, la réalisation d'un tel dispositif ne nécessite pas de conserver des portions de silicium pour déposer la couche de semi-conducteur destinée à former le canal, supprimant ainsi le problème de barrière de potentiel à l'interface avec le matériau de la couche de semi-conducteur.

Le dispositif microélectronique comporte une architecture de type « GAA stacked-nanosheet », ou à nanofeuilles empilées et grille totalement enrobante.

Lorsque le dispositif comporte la couche de diélectrique de grille, le dispositif peut correspondre à un transistor de type GAA à nanofils ou « nano-sheets » empilés, ou CFET. Lorsque le dispositif comporte la couche mémoire ferroélectrique, le dispositif peut correspondre à un dispositif mémoire de type FeFET.

La couche de semi-conducteur peut comporter un matériau bidimensionnel ou tout autre matériau semi-conducteur déposé par MOCVD (« Metal Organic Chemical Vapor Deposition » en anglais, ou dépôt chimique en phase vapeur aux organométalliques), CVD (« Chemical Vapor Deposition » en anglais, ou dépôt chimique en phase valeur) ou ALD (« Atomic Layer Deposition » en anglais, ou dépôt en couche atomique). Dans ce cas, le dispositif microélectronique peut être réalisé avec de très faibles dimensions.

Le dispositif microélectronique peut être tel que :
- chacune des régions de source / drain soit disposée dans une cavité comprenant des parois latérales formées au moins par les espaceurs diélectriques et par un matériau diélectrique d'isolation ou par les espaceurs diélectriques et par des espaceurs d'un dispositif microélectronique voisin ;
- les deuxièmes zones de la couche de semi-conducteur recouvrent au moins une partie des parois des cavités dans lesquelles sont disposées les régions de source / drain.

De préférence, la couche de diélectrique ou de mémoire ferroélectrique est en contact avec un fond et lesdites parois latérales des cavités dans lesquelles sont disposées les régions de source / drain, les deuxièmes zones de la couche de semi-conducteur recouvrant ici la couche de diélectrique ou de mémoire ferroélectrique au niveau du fond et desdites parois latérales des cavités.

Dans la configuration ci-dessus, les surfaces de contact des régions de source / drain avec la couche de semi-conducteur sont maximisées grâce à l'utilisation de la surface des parois des cavités, et avantageusement l'ensemble de la surface des parois de la cavité, pour former le contact entre les deuxièmes zones de la couche de semi-conducteur et les régions de source / drain, ce qui permet d'avoir de très faibles résistances de contact des régions de source / drain, et donc un plus fort courant parcourant le canal de conduction du dispositif.

Chacune des premières zones de la couche de semi-conducteur peut être entourée par une même grille de commande électrostatique ou par une grille de commande électrostatique différente de celle entourant les autres premières zones de la couche de semi-conducteur.

Dans une première option de réalisation, le dispositif microélectronique peut comporter en outre une ou plusieurs portions diélectriques chacune entourée par l'une des premières zones de la couche de semi-conducteur et telles que chacune des portions diélectriques soit entourée par les premières zones de la couche de semi-conducteur. Ces portions diélectriques peuvent servir à combler un ou des espaces entre les premières zones de la couche de semi-conducteur.

Dans une seconde option de réalisation, chacune des premières zones de la couche de semi-conducteur n'entoure pas de portion diélectrique.

Le dispositif peut comporter en outre des espaceurs diélectriques internes disposés contre des flancs d'une ou plusieurs parties de la grille de commande électrostatique. De tels espaceurs internes sont avantageux car ils permettent de réduire les capacités parasites au sein du dispositif.

De manière avantageuse, l'invention peut s'appliquer pour la réalisation de composants CMOS pour les nœuds technologiques 5 nm et sub-5nm.

L'invention concerne également un composant microélectronique comportant plusieurs dispositifs microélectroniques tels que décrit précédemment, et dans lequel :
- les grilles de commande électrostatiques de plusieurs des dispositifs microélectroniques sont communes et formées par les mêmes portions de matériau, et/ou
- l'une des régions de source / drain est commune à deux des dispositifs microélectroniques voisins.

L'invention concerne également un procédé de réalisation d'au moins un dispositif microélectronique comprenant au moins :
a) réalisation, sur un substrat, d'au moins un empilement alterné de portions d'un premier matériau et de portions d'un deuxième matériau, les premier et deuxième matériaux étant aptes à être gravés sélectivement l'un vis-à-vis de l'autre, puis
b) réalisation d'une grille temporaire recouvrant une partie d'une face supérieure et de faces latérales de l'empilement, puis
c) réalisation d'espaceurs diélectriques contre des flancs, ou parois latérales, de la grille temporaire, puis
d) gravure de parties de l'empilement non recouvertes par la grille temporaire et les espaceurs diélectriques, puis
e) gravure de la grille temporaire (selon une approche dite gate-last), puis
f) gravure des portions du premier matériau sélectivement vis-à-vis des portions du deuxième matériau, puis
g) réalisation d'au moins une partie d'une grille de commande électrostatique dans un espace formé par la gravure de la grille temporaire, telle que les espaceurs diélectriques soient disposés contre les flancs de la grille de commande électrostatique, puis
h) gravure des portions du deuxième matériau, puis
i) réalisation d'une couche de semi-conducteur, avantageusement un matériau 2D dont l'épaisseur peut être comprise entre 1 et 5 couches atomiques, comprenant plusieurs premières zones configurées pour former un canal de conduction électrique du dispositif microélectronique et disposées contre la grille dans des emplacements formés par la gravure des portions du deuxième matériau, la couche de semi-conducteur se prolongeant, sans discontinuité avec les premières zones, en formant des deuxièmes zones couvrant au moins une partie des flancs des espaceurs diélectriques et qui ne sont pas disposées directement contre la grille de commande électrostatique, puis
j) réalisation, sur le substrat, des régions de source / drain couplées électriquement aux premières zones de la couche de semi-conducteur par les deuxièmes zones de la couche de semi-conducteur, et telles que les deuxièmes zones de la couche de semi-conducteur s'étendent entre chacune des régions de source / drain et les espaceurs diélectriques et comportant en outre une étape de dépôt d'une couche de diélectrique de grille ou d'une couche mémoire ferroélectrique mise en œuvre :
   - selon un exemple ne faisant pas partie de la présente invention mais utile pour sa compréhension, entre les étapes f) et g), dans l'espace formé par la gravure de la grille temporaire, la grille de commande électrostatique étant réalisée ensuite sur la couche de diélectrique de grille ou la couche mémoire ferroélectrique, et/ou
   - selon l'invention, entre les étapes h) et i), dans les emplacements formés par la gravure des portions du deuxième matériau, la couche de semi-conducteur étant réalisée ensuite en recouvrant la couche de diélectrique de grille ou la couche mémoire ferroélectrique, les deuxièmes zones de la couche de semi-conducteur étant disposées directement contre et en contact avec la couche de diélectrique ou de mémoire ferroélectrique et formant, avec les premières zones, une couche continue.

Le procédé peut comporter en outre, avant la mise en œuvre de l'étape c), un dépôt d'un matériau diélectrique d'isolation autour des espaceurs diélectriques, puis une gravure de cavités dans le matériau diélectrique d'isolation telle que chacune des cavités comprenne au moins une paroi latérale formée par l'un des espaceurs diélectriques, et :
- l'étape i) peut être mise en œuvre telle que les deuxièmes zones de la couche de semi-conducteur recouvrent au moins une partie des parois latérales des cavités, et
- l'étape j) peut être mise en œuvre telle que chacune des régions de source / drain soit disposée dans une des cavités.

Selon une première option de réalisation, l'étape i) peut être mise en œuvre telle que les premières zones de la couche de semi-conducteur recouvrent des parois des emplacements formés par la gravure des portions du deuxième matériau, et le procédé peut comporter en outre, entre les étapes i) et j), une réalisation de portions diélectriques dans des espaces restants des emplacements et telles que chacune des portions diélectriques soient entourées par les premières zones de la couche de semi-conducteur.

Selon une deuxième option de réalisation, l'étape i) peut être mise en œuvre telle que les premières zones de la couche de semi-conducteur remplissent complètement les emplacements formés par la gravure des portions du deuxième matériau.

Le procédé peut comporter en outre, entre les étapes d) et e), une gravure de parties des portions du premier matériau disposées à l'aplomb des espaceurs diélectriques, et une réalisation d'espaceurs diélectriques internes à la place des parties gravées des portions du premier matériau.

Avantageusement, la couche de diélectrique de grille ou la couche mémoire ferroélectrique est réalisée par dépôt sur l'ensemble d'une structure en cours de réalisation, la couche de semi-conducteur est réalisée à l'étape i), après la couche de diélectrique de grille ou la couche mémoire ferroélectrique, sur l'ensemble de la structure en recouvrant la couche de diélectrique de grille ou la couche mémoire ferroélectrique.

Ainsi, la couche de diélectrique de grille ou la couche mémoire ferroélectrique forme une couche « tampon » unique sur laquelle on forme la couche de semi-conducteur, avantageusement en matériau 2D. Le fait de déposer la couche de semi-conducteur sur un seul matériau plutôt que sur plusieurs, permet d'obtenir une croissance homogène et mieux contrôlée du matériau 2D. On peut ainsi obtenir une couche de matériau semi-conducteur d'épaisseur homogène avec des propriétés bien contrôlées.

Lorsque la couche de diélectrique de grille est déposée entre les étapes h) et i), la couche de semi-conducteur est déposée sur un seul matériau, celui de la couche de diélectrique de grille. La couche de semi-conducteur peut être formée à l'étape i) uniquement sur la couche de diélectrique de grille ou la couche mémoire ferroélectrique.

Dans l'ensemble du document, les termes « sur » et « sous » sont utilisés sans distinction de l'orientation dans l'espace de l'élément auquel se rapporte ce terme. Par exemple, dans la caractéristique « sur une face du premier substrat », cette face du premier substrat n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments. Dans tout le document, le terme « couche » peut désigner une seule couche ou un empilement de plusieurs couches.

Dans l'ensemble du document, l'expression « coupler électriquement » est utilisée pour désigner une liaison électrique pouvant être directe ou pouvant être indirecte (c'est-à-dire réaliser à travers un ou plusieurs éléments électriques intermédiaires).

Selon un un exemple ne faisant pas partie de la présente invention mais utile pour sa compréhension, la présente demande propose un procédé de réalisation d'un dispositif microélectronique dont la structure soit compatible avec tout type de matériau semi-conducteur dont les matériaux 2D, et ne présentant pas les inconvénients d'une configuration « side contact ».

Pour cela, on prévoit un procédé de réalisation d'au moins un dispositif microélectronique, comprenant au moins :
a) réalisation, sur un substrat, d'au moins un empilement alterné de portions d'un premier matériau et de portions d'un deuxième matériau, les premier et deuxième matériaux étant aptes à être gravés sélectivement l'un vis-à-vis de l'autre, puis
b) réalisation d'une grille temporaire recouvrant une partie d'une face supérieure et de faces latérales de l'empilement, puis
c) réalisation d'espaceurs diélectriques contre des flancs, ou parois latérales, de la grille temporaire, puis
d) gravure de parties de l'empilement non recouvertes par la grille temporaire et les espaceurs diélectriques, puis
e) dépôt d'un matériau diélectrique d'isolation autour des espaceurs diélectriques, puis
f) gravure de la grille temporaire (selon une approche dite gate-last), puis
g) gravure des portions du premier matériau sélectivement vis-à-vis des portions du deuxième matériau, puis
h) réalisation d'au moins une partie d'une grille de commande électrostatique dans un espace formé par la gravure de la grille temporaire, telle que les espaceurs diélectriques soient disposés contre les flancs de la grille de commande électrostatique, puis,
i) gravure de cavités (150) dans le matériau diélectrique d'isolation (128), puis
j) gravure des portions du deuxième matériau, puis
k) réalisation d'une couche de semi-conducteur comprenant plusieurs premières zones configurées pour former un canal de conduction électrique du dispositif microélectronique et disposées dans des emplacements formés par la gravure des portions du deuxième matériau, la couche de semi-conducteur se prolongeant, sans discontinuité avec les premières zones, en formant des deuxièmes zones couvrant au moins une partie des flancs des espaceurs diélectriques et qui ne sont pas disposées directement contre la grille de commande électrostatique, puis
l) réalisation, sur le substrat et dans les cavités, de régions de contact couplées électriquement aux premières zones de la couche de semi-conducteur par les deuxièmes zones de la couche de semi-conducteur, et telles que les deuxièmes zones de la couche de semi-conducteur s'étendent au moins entre chacune des régions de contact et les espaceurs diélectriques.

La mise en œuvre de ce procédé permet de réaliser un dispositif microélectronique dont l'architecture ne comporte pas d'interface de type « side contact » entre le canal et les régions de contact (qui correspondent par exemple à des régions de source et de drain lorsque le dispositif microélectronique correspond à un transistor) grâce aux deuxièmes zones de la couche de semi-conducteur qui réalisent le couplage électrique entre le canal formé par les premières zones de la couche de semi-conducteur et les régions de contact. Ces deuxièmes zones de la couche de semi-conducteur, qui s'étendent contre au moins une partie des parois latérales, ou flancs, des régions de contact, forment une grande surface de contact avec les régions de contact, ce qui permet de réduire les résistances de contact de ces régions. Ainsi, le courant électrique circulant dans le canal n'est pas réduit à cause de ces résistances de contact, ce qui ne réduit pas les performances du dispositif. De plus, dans ce procédé, la couche de semi-conducteur est réalisée après la grille de commande électrostatique et après avoir gravé les portions du deuxième matériau, et avant la réalisation des régions de contact. Ainsi, la couche de semi-conducteur dont les premières zones sont destinées à former le canal de conduction n'est pas détériorée par les étapes liées à la réalisation de la grille de commande électrostatique ou par la réalisation des espaceurs internes s'ils ont été réalisés. Cela est particulièrement avantageux lorsque la couche de semi-conducteur comporte un matériau 2D.

En outre, ce procédé ne nécessite pas de conserver des portions de silicium pour déposer la couche de semi-conducteur destinée à former le canal, supprimant ainsi le problème de barrière de potentiel à l'interface avec le matériau de la couche de semi-conducteur. Le dispositif microélectronique obtenu par la mise en œuvre de ce procédé peut comporter une architecture de type « GAA stacked-nanosheet », ou à nanofeuilles empilées et grille totalement enrobante.

Dans tout le document, l'expression « région de contact » désigne les régions conductrices du dispositif microélectronique par lesquelles le canal de conduction du dispositif est accessible électriquement. Par exemple, lorsque le dispositif microélectronique correspond à un transistor ou un ensemble de transistors, ces régions de contact correspondent à des régions de source et de drain. Une ou plusieurs de ces régions de source et de drain peuvent être communes à plusieurs transistors. Lorsque le dispositif microélectronique correspond à un dispositif mémoire, l'une de ces régions de contact peut correspondre à une électrode d'accès du dispositif mémoire et l'autre région de contact peut comporter un empilement mémoire, c'est-à-dire un empilement de matériaux configuré pour réaliser une mémorisation d'information.

La couche de semi-conducteur peut comporter un matériau bidimensionnel ou tout autre matériau semi-conducteur déposé par MOCVD (« Metal Organic Chemical Vapor Deposition » en anglais, ou dépôt chimique en phase vapeur aux organométalliques), CVD (« Chemical Vapor Deposition » en anglais, ou dépôt chimique en phase valeur) ou ALD (« Atomic Layer Deposition » en anglais, ou dépôt en couche atomique). Dans ce cas, le dispositif microélectronique peut être réalisé avec de très faibles dimensions.

Les cavités peuvent être gravées telles que chacune d'elles comprenne au moins une paroi latérale formée par l'un des espaceurs diélectriques, et dans lequel l'étape k) est mise en œuvre telle que les deuxièmes zones de la couche de semi-conducteur recouvrent au moins une partie des parois des cavités.

Dans la configuration ci-dessus, les surfaces de contact entre les régions de contact et la couche de semi-conducteur sont maximisées grâce à l'utilisation de la surface des parois des cavités, et avantageusement l'ensemble de la surface des parois des cavités, pour former le contact entre les deuxièmes zones de la couche de semi-conducteur et les régions de contact, ce qui permet d'avoir de très faibles résistances de contact des régions de contact, et donc un plus fort courant parcourant le canal de conduction du dispositif.

Le procédé peut comporter en outre une étape de dépôt d'une couche de diélectrique de grille mise en œuvre :
- selon un exemple ne faisant pas partie de la présente invention mais utile pour sa compréhension, entre les étapes g) et h), dans l'espace formé par la gravure de la grille temporaire, la grille de commande électrostatique étant réalisée ensuite sur la couche de diélectrique de grille, et/ou
- selon l'invention, entre les étapes i) et k), dans les emplacements formés par la gravure des portions du deuxième matériau, la couche de semi-conducteur étant réalisée ensuite en recouvrant la couche de diélectrique de grille, les deuxièmes zones de la couche de semi-conducteur étant disposées directement contre et en contact avec la couche de diélectrique de grille, avec les premières zones, une couche continue.

Lorsque la couche de diélectrique de grille est déposée entre les étapes g) et h), la grille de commande électrostatique est protégée lors de l'étape j) de gravure.

Lorsque la couche de diélectrique de grille est déposée entre les étapes i) et k), la couche de semi-conducteur est déposée sur un seul matériau, celui de la couche de diélectrique de grille.

Chacune des premières zones de la couche de semi-conducteur peut être entourée par une même grille de commande électrostatique ou par une grille de commande électrostatique différente de celle entourant les autres premières zones de la couche de semi-conducteur.

Dans une première option de réalisation, l'étape k) peut être mise en œuvre telle que les premières zones de la couche de semi-conducteur recouvrent des parois des emplacements formés par la gravure des portions du deuxième matériau, et le procédé peut comporter en outre, entre les étapes k) et l), une réalisation de portions diélectriques dans des espaces restants des emplacements et telles que chacune des portions diélectriques soient entourées par l'une des premières zones de la couche de semi-conducteur. Ces portions diélectriques peuvent servir à combler des espaces non remplis par les premières zones de la couche de semi-conducteur.

Dans une seconde option de réalisation, l'étape i) peut être mise en œuvre telle que les premières zones de la couche de semi-conducteur remplissent complètement les emplacements formés par la gravure des portions du deuxième matériau.

Le procédé peut comporter en outre, entre les étapes d) et e), une gravure de parties des portions du premier matériau disposées à l'aplomb des espaceurs diélectriques, et une réalisation d'espaceurs diélectriques internes à la place des parties gravées des portions du premier matériau. De tels espaceurs internes sont avantageux car ils permettent de réduire les capacités parasites au sein du dispositif.

Les régions de contact peuvent comporter chacune un matériau électriquement conducteur ou une combinaison de matériaux électriquement conducteurs, et peuvent correspondre à des régions de source et de drain du dispositif microélectronique. Dans ce cas, le dispositif microélectronique peut correspondre à un ou plusieurs transistors à effet de champ.

Dans une autre configuration, l'une des régions de contact peut être réalisée telle qu'elle comporte au moins un empilement mémoire, c'est-à-dire une succession de matériaux avec lesquels il est possible de réaliser une mémorisation d'information, interposé entre une première portion conductrice, reliant électriquement l'empilement mémoire à la couche de semi-conducteur, et une deuxième portion conductrice formant un contact électrique de l'empilement mémoire. Dans ce cas, le dispositif microélectronique peut former un dispositif mémoire de type 1T1C ou 1T1R ou 2T1C ou 2T1R. Suivant la nature du matériau utilisé pour réaliser la couche mémoire faisant partie de l'empilement mémoire, le dispositif mémoire peut être par exemple de type FeRAM ou OxRAM ou CBRAM. Un tel empilement mémoire correspond par exemple à un empilement de type MIM (métal - isolant - métal).

L'empilement mémoire peut comporter une couche de matériau ferroélectrique ou une couche d'oxyde ou une couche ionique.

L'invention concerne également un procédé de réalisation d'un composant microélectronique, dans lequel les étapes d'un procédé tel que décrit ci-dessus peuvent être mises en œuvre tels que plusieurs dispositifs microélectroniques soient réalisés collectivement sur le substrat. Les dispositifs microélectroniques du composant peuvent être de même nature ou être configurés pour remplir des fonctions différentes.

Dans ce cas, les grilles de commande électrostatique de plusieurs dispositifs microélectroniques peuvent être communes à ces dispositifs microélectroniques et formées par les mêmes portions de matériau.

Au moins une des régions de contact peut être commune à deux dispositifs microélectroniques voisins.

De manière avantageuse, l'invention peut s'appliquer pour la réalisation de composants CMOS pour les nœuds technologiques 5 nm et sub-5nm.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
[Fig. 1]
[Fig. 2]
[Fig. 3]
[Fig. 4]
[Fig. 5]
[Fig. 6]
[Fig. 7]
[Fig. 8]
[Fig. 9]
[Fig. 10]
[Fig. 11]
[Fig. 12]
[Fig. 13]
[Fig. 14]
[Fig. 15], et
[Fig. 16] représentent schématiquement les étapes d'un procédé de réalisation d'un dispositif microélectronique, selon un exemple ne faisant pas partie de la présente invention mais utile pour sa compréhension;
[Fig. 17]
[Fig. 18]

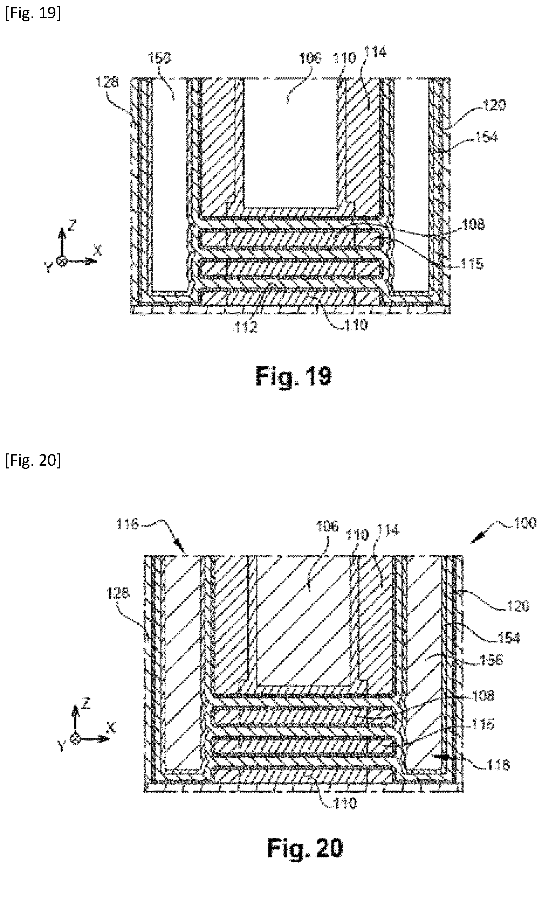

[Fig. 19], et
[Fig. 20] représentent schématiquement une partie des étapes d'un procédé de réalisation du dispositif microélectronique, objet de la présente invention, selon une variante de réalisation.

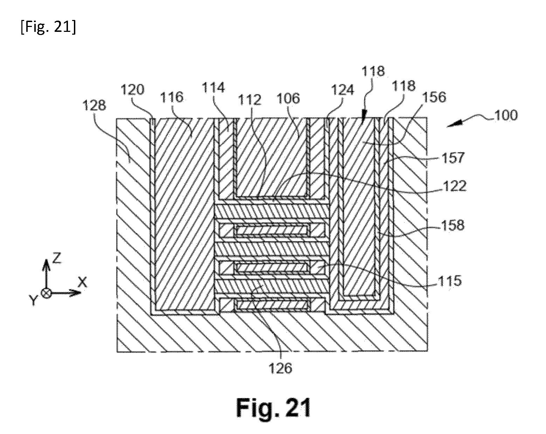

[Fig. 21] représente schématiquement une partie d'un dispositif microélectronique, obtenu par la mise en œuvre d'un procédé selon une autre exemple ne faisant pas partie de la présente invention mais utile pour sa compréhension.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### Exposé détaillé de modes de réalisation particuliers

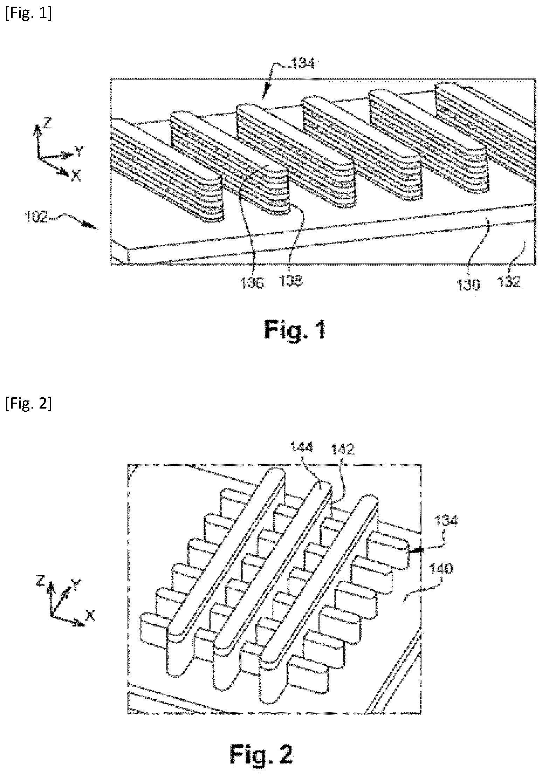

Un exemple de procédé de réalisation d'un dispositif microélectronique 100 selon un un exemple de réalisation ne faisant pas partie de la présente invention mais utile pour sa compréhension est décrit ci-dessous en lien avec les figures 1 à 16. Sur ces figures, la réalisation simultanée de plusieurs dispositifs microélectroniques 100 est représentée, ces dispositifs faisant partie d'un composant électronique 1000.

Un empilement alterné de couches comprenant un premier matériau et un deuxième matériau aptes à être gravés sélectivement l'un vis-à-vis de l'autre est tout d'abord réalisé sur un substrat 102. Selon un exemple avantageux, les premier et deuxième matériaux correspondent respectivement à du Si et du SiGe. D'autres couples de premier et deuxième matériaux sont également possibles : SiGe et Ge, Ge et GeSn, SiO₂ et silicium amorphe (a-Si). Plus généralement, il peut être envisagé d'utiliser, pour former cette alternance de couches des premier et deuxième matériaux, deux semi-conducteurs aptes à être gravés sélectivement l'un par rapport à l'autre, ou un matériau diélectrique et un semi-conducteur amorphe.

Le nombre de couches de cet empilement dépend du nombre de niveau de matériau semi-conducteur souhaité pour former le canal du dispositif 100. Dans l'exemple de réalisation décrit en lien avec les figures 1 à 16, l'empilement de couches comporte quatre couches de silicium empilées de manière alternée avec trois couches de SiGe. De manière avantageuse, le nombre de couches du premier matériau est compris entre 2 et 10, et le nombre de couches du deuxième matériau est compris entre 1 et 10.

A titre d'exemple, chacune des couches de l'empilement a une épaisseur comprise entre 5 nm et 25 nm, et par exemple égale à 12 nm.

Dans l'exemple de réalisation décrit en lien avec les figures 1 à 16, le substrat 102 correspond à un substrat SOI, c'est-à-dire comprenant une couche superficielle de silicium formant la première couche de l'empilement réalisé et qui est disposé sur une couche diélectrique enterrée 130 comprenant par exemple du SiO₂. La couche diélectrique enterrée 130 est disposée sur une couche support 132 comprenant par exemple du silicium. De manière alternative, le substrat 102 peut correspondre à un substrat de type autre que SOI, par exemple un substrat « bulk », ou substrat massif, de semi-conducteur (par exemple de silicium).

Une gravure de l'empilement de couches réalisé est ensuite mise en œuvre afin de former, sur le substrat 102 (sur la couche diélectrique enterrée 130 dans cet exemple), au moins un empilement 134 alterné de portions 136 du premier matériau et de portions 138 du deuxième matériau. Sur la figure 1, six empilements 134 distincts sont représentés, chacun comprenant quatre portions 136 et trois portions 138 empilées de manière alternée les unes sur les autres.

Chacun des empilements 134 a une forme sensiblement allongée, c'est-à-dire comporte une longueur (dimension selon l'axe X) supérieure à sa largeur (dimension selon l'axe Y). La largeur de chaque empilement 134 est par exemple comprise entre 20 nm et 200 nm, et la longueur de chaque empilement 134 est par exemple supérieure à 100 nm.

Une fine couche diélectrique 140, dont l'épaisseur est inférieure à 10 nm et par exemple égale à 7 nm ou 4 nm, est ensuite déposée de manière conforme sur l'ensemble de la structure, c'est-à-dire en couvrant les faces supérieures et les faces latérales des empilements 134 et les parties du substrat 102 (de la couche diélectrique enterrée 130 dans l'exemple de réalisation décrit) non recouvertes par les empilements 134. La couche diélectrique 140 comporte par exemple du SiO₂, pouvant être obtenu à partir de TEOS. Au moins une grille temporaire 142 est ensuite réalisée, couvrant une partie d'une face supérieure et des faces latérales des empilements 134.

Pour cela, un matériau adapté à la réalisation des grilles temporaires est déposé sur l'ensemble de la structure. De manière avantageuse, le matériau déposé est du silicium polycristallin. L'épaisseur de matériau déposé est supérieure à la somme des épaisseurs d'un des empilements 134 et de la couche diélectrique 140, par exemple égale à 380 nm. Une planarisation, par exemple une CMP (planarisation mécano-chimique), du matériau déposé est ensuite mise en œuvre afin qu'une épaisseur donnée, par exemple égale à 70 nm, soit conservée au-dessus des empilements 134. Un masque dur 144 est ensuite réalisé sur le matériau restant après la planarisation, le motif de ce masque dur définissant celui du ou des grilles temporaires 142 à réaliser. Par exemple, le masque dur 144 comporte une bicouche nitrure de semi-conducteur / oxyde de semi-conducteur tel que du SiN/SiO₂. Le matériau restant adapté à la réalisation des grilles temporaires est ensuite gravé conformément au motif défini par le masque dur 144, formant la ou les grilles temporaires 142. Dans l'exemple décrit, plusieurs grilles temporaires 142 sont réalisées (trois grilles temporaires 142 sont visibles sur la figure 2, chacune formée en couvrant les six empilements 134).

À titre d'exemple, la largeur (dimension selon l'axe X visible sur la figure 2) de chaque grille temporaire 142 est par exemple comprise entre 10 nm et plusieurs centaines de nm, et la longueur (dimension selon l'axe Y visible sur la figure 2) de chaque grille temporaire 142 dépend du nombre d'empilements 134 sur lesquels les grilles temporaire 142 doivent être réalisées, et par exemple égale à plusieurs dizaines de nm.

Des espaceurs diélectriques 114 sont ensuite réalisés contre des flancs des grilles temporaires 142. Pour cela, une couche de matériau adapté à la réalisation de ces espaceurs 114 est déposée de manière conforme sur l'ensemble de la structure, c'est-à-dire en recouvrant les faces supérieures et les faces latérales des empilements 134, des grilles temporaires 142 et des masques durs 144 et les parties du substrat 102 (de la couche diélectrique enterrée 130 dans l'exemple de réalisation décrit) non recouvertes par les empilements 134 et les grilles temporaires 142. Ce matériau adapté à la réalisation des espaceurs diélectriques 114 correspond par exemple à du SiN, du SiCO ou du SiBCN. L'épaisseur de cette couche est par exemple comprise entre 5 nm et 15 nm.

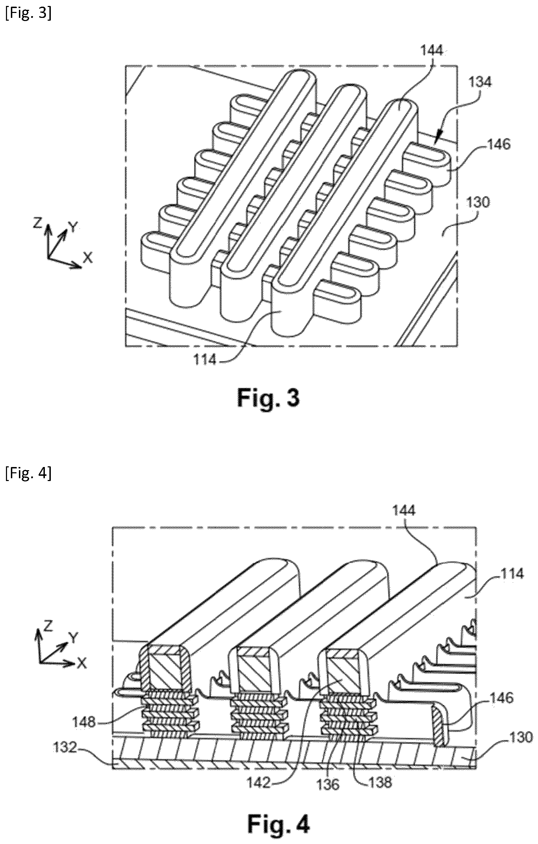

Une gravure anisotrope de cette couche est ensuite mise en œuvre telle que des portions restantes de cette couche disposées contre les flancs des grilles temporaires 142 forment les espaceurs diélectriques 114 (voir figure 3). Des portions restantes 146 de cette couche disposées contre les flancs des empilements 134 peuvent être conservées à l'issue de cette gravure, ou bien être avantageusement supprimées. La gravure anisotrope est mise en œuvre de manière à supprimer le matériau localisé sur les faces supérieures des grilles temporaires 142 et des empilements 134. En outre, cette gravure supprime également les parties de la couche 140 qui ne sont pas recouvertes par les grilles temporaires 142 et les espaceurs diélectriques 114.

Les parties des empilements 134 non recouvertes par les grilles temporaires 142, par les espaceurs diélectriques 114 ou par les portions restantes 146 sont gravées. Cette gravure est stoppée sur la couche diélectrique enterrée 130. Les parties restantes des portions 136 sont ensuite gravées partiellement et sélectivement vis-à-vis des parties restantes des portions 138, de manière à former, à l'aplomb des espaceurs diélectriques 114, des espaces 148 au-dessus et en dessous des extrémités des parties restantes des portions 138 (voir figure 4). La profondeur (dimension selon l'axe X sur la figure 4) gravée dans les parties restantes des portions 136 est par exemple comprise entre 5 nm et 15 nm.

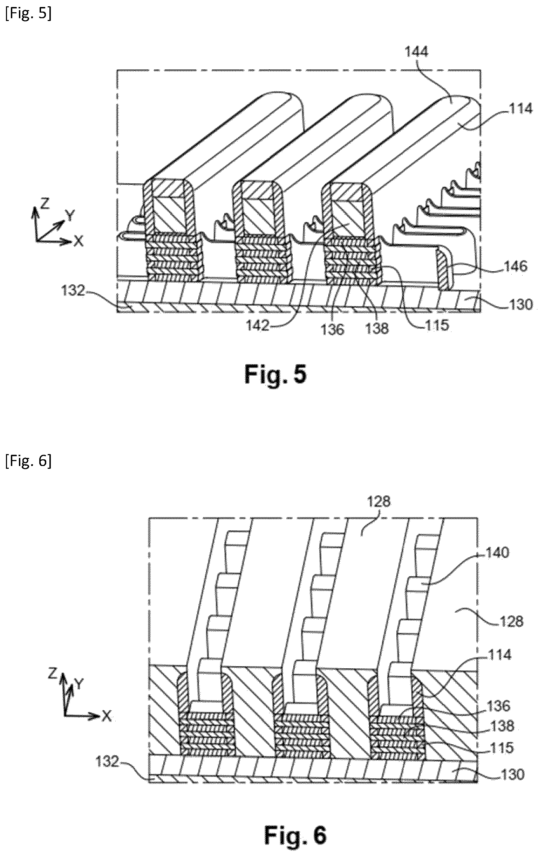

Les espaceurs diélectriques internes 115 sont ensuite réalisés dans les espaces 148 précédemment formés. Ces espaceurs diélectriques internes 115 sont obtenus en déposant un matériau diélectrique, par exemple du SiN, du SiBCN ou du SiCO de manière au moins à remplir les espaces 148. Le matériau déposé en dehors des espaces 148 est gravé de manière isotrope afin de ne conserver que les espaceurs diélectriques internes 115 (voir figure 5).

Un matériau diélectrique d'isolation 128, par exemple du SiO₂, est ensuite déposé autour des espaceurs diélectriques 114. Pour cela, le matériau diélectrique d'isolation 128 est déposé avec une forte épaisseur, puis une planarisation est mise en œuvre jusqu'à atteindre le masque dur 144. Le masque dur 144 est ensuite retiré par exemple par gravure humide, par exemple à l'aide d'une solution de H₃PO₄ diluée et utilisée à une température de 110°C. Les grilles temporaires 142 sont ensuite retirées, par exemple par gravure en utilisant une solution d'HF diluée à 0,5 % combinée à une solution de HCl diluée à 1 % et avec une solution de TMAH à 5 %. Cette gravure est stoppée lorsque les parties restantes de la couche diélectrique 140 sont atteintes (voir figure 6).

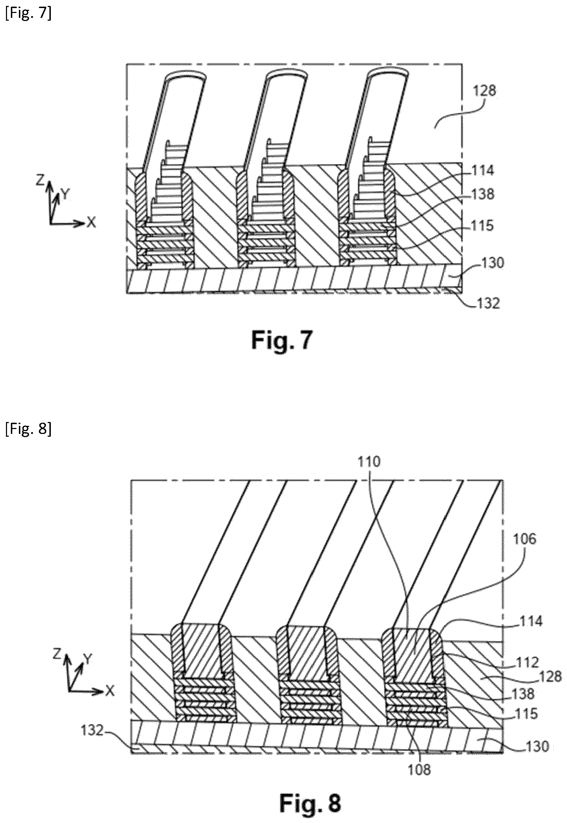

Les parties restantes de la couche diélectrique 140 sont ensuite gravées, puis les parties restantes des portions 136 sont gravées sélectivement vis-à-vis des parties restantes des portions 138, par exemple en mettant en œuvre une gravure humide. La structure obtenue à ce stade est représentée sur la figure 7.

Au moins une couche 112 destinée, dans l'exemple de réalisation décrit ici, à former les diélectriques de grille est ensuite déposée de manière conforme, notamment dans les espaces formés par la gravure des grilles temporaires 142 en recouvrant les parois formées par les espaceurs diélectriques 114 et les parties restantes des portions 138. Par exemple, cette couche 112 comporte par exemple un matériau diélectrique high-K (à forte permittivité diélectrique) tel que du HfO₂. En variante, cette couche 112 destinée à former les diélectriques de grille peut comporter du SiO₂ ou de l'Al₂O₃ ou tout autre matériau ou combinaison de matériaux adaptés.

Des grilles de commande électrostatique 110 sont réalisées par dépôt d'un ou plusieurs matériaux conducteurs sur la couche 112 destinée à former les diélectriques de grille, par un premier dépôt d'une fine couche de TiN (épaisseur par exemple égale à 3 nm) sur laquelle est empilée une couche de tungstène d'épaisseur par exemple égale à 200 nm. Dans l'exemple visible sur la figure 8, chacune des grilles 110 comporte une partie supérieure 106 et d'autres parties 108 entourant les parties restantes des portions 138. Il est en outre possible que les grilles 110 comportent un ou plusieurs matériaux différents du TiN et du W, comme par exemple du polysilicium dopé ou tout autre métal (Mo, etc.).

Une planarisation avec arrêt sur le matériau diélectrique d'isolation 128 est mise en œuvre pour supprimer le ou les matériaux de la couche 112 destinée à former les diélectriques de grille et les grilles de commande électrostatique 110 déposés en dehors des espaces formés par la gravure des grilles temporaires 142.

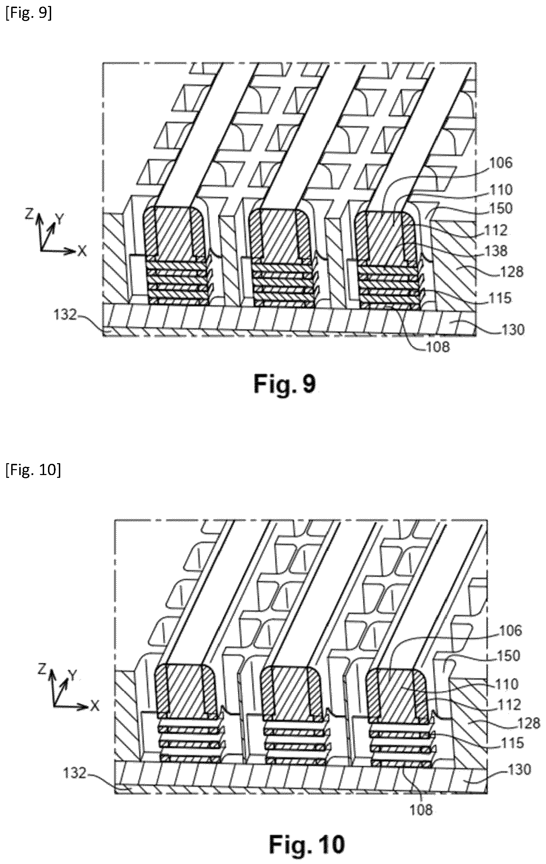

Une gravure d'une partie du matériau diélectrique d'isolation 128 est ensuite mise en œuvre de manière à former des cavités 150 comprenant des parois latérales formées par les espaceurs diélectriques 114, les espaceurs diélectriques internes 115 et, dans l'exemple décrit ici, des portions restantes du matériau diélectrique d'isolation 128 (voir figure 9). Ces cavités 150 forment des emplacements pour la réalisation des régions de source 116 et de drain 118 des dispositifs 100.

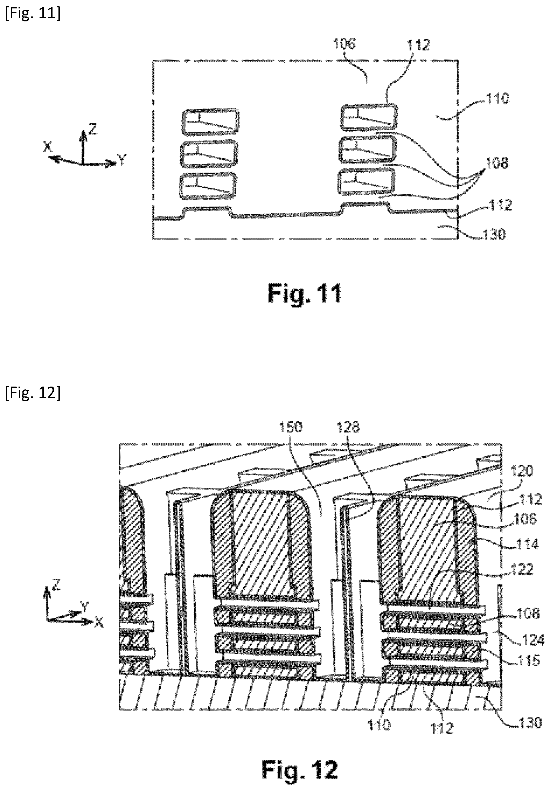

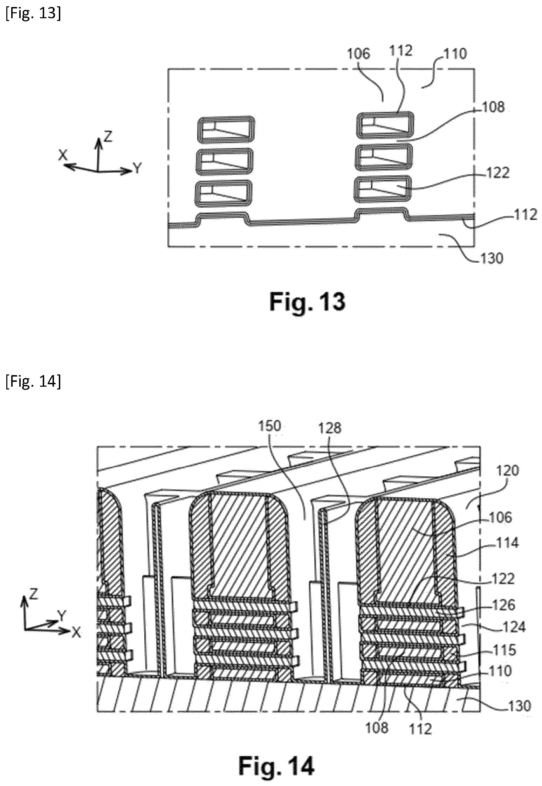

Les portions 138 sont ensuite gravées, par exemple par la mise en œuvre d'une gravure chimique utilisant une solution d'Hf-H₂O₂ (voir figures 10 et 11) lorsque les portions 138 comportent du SiGe. Comme cela est visible sur la figure 11 représentant une vue en coupe selon l'axe XX' représenté sur la figure 10, cette gravure forme des espaces en forme de tunnels dans lesquels les canaux des transistors sont destinés à être réalisés. Une couche de semi-conducteur 120 est ensuite déposée sur l'ensemble de la structure réalisée à ce stade du procédé (voir figures 12 et 13). Des premières zones 122 de cette couche de semi-conducteur 120 qui sont localisées dans les espaces en forme de tunnels précédemment réalisés sont destinées à former les canaux des transistors et sont disposées contre les diélectriques de grille. Des deuxièmes zones 124 de cette couche de semi-conducteur 120 qui recouvrent les parois (parois latérales et parois de fond dans l'exemple décrit ici) des cavités 150 sont destinées à être en contact avec les régions de source 116 / drain 118 qui seront ensuite réalisées. Le dépôt est réalisé sans discontinuité, ou sans interruption, entre les premières et deuxièmes zones 122 et 124. De manière avantageuse, la couche de semi-conducteur 120 comporte au moins un matériau semi-conducteur 2D, par exemple un dichalcogénure de métaux de transition tel que du MoS₂, ou du WSe₂, ou du WS₂, ou du MoTe₂. Il est également possible que le matériau de la couche de semi-conducteur 120 corresponde à de l'IGZO, de l'In₂O₃, de l'IWO, de l'ITO, ou un oxyde de semi-conducteur amorphe, ou tout autre matériau semi-conducteur adapté.

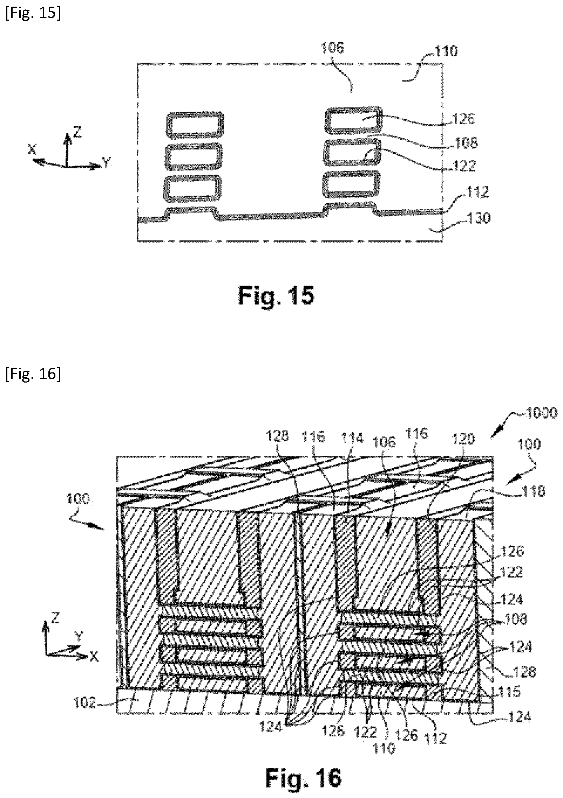

Une ou plusieurs couches diélectriques, comprenant par exemple de l'Al₂O₃ (ou du HfO₂) et/ou du SiO₂ (ou un diélectrique low-k, ou à faible permittivité diélectrique), sont ensuite déposées puis gravées de manière isotrope afin de ne conserver que des portions 126 localisées dans les espaces en forme de tunnels (voir figures 14 et 15). Ces portions 126 forment des barreaux diélectriques chacun entouré par l'une des premières zones 122 de la couche de semi-conducteur 120. Ainsi, la couche de semi-conducteur 120 comporte plusieurs premières zones 122 superposées les unes au-dessus des autres par l'intermédiaire d'une succession de barreaux 126 et de parties 108 de la grille 110 et de diélectriques de grille.

Enfin, des régions de source / drain sont réalisées en déposant, dans l'exemple décrit, un ou plusieurs matériaux métalliques dans les cavités 150. Avant ce ou ces dépôts métalliques, il est possible de déposer une couche de graphène dans les cavités 150, ce ou ces métaux étant ensuite déposés sur la couche de graphène. Ces régions de source 116 et de drain 118 sur la figure 16, se retrouvent couplées électriquement aux premières zones 122 de la couche de semi-conducteur 120 par l'intermédiaire des deuxièmes zones 124 de la couche de semi-conducteur 120 qui s'étendent entre les régions de source 116 / drain 118 et les espaceurs diélectriques 114 ainsi que contre les autres parois des régions de source 116 / drain 118 localisées dans les cavités 150. Le matériau de ces régions déposé en dehors des cavités 150 est supprimé par la mise en œuvre d'une planarisation avec arrêt sur le matériau diélectrique d'isolation 128.

De manière avantageuse, les régions de source 116 / drain 118 comportent au moins un matériau métallique tel que de l'or, du palladium, du TiN, du W, du Ni, etc. Selon un exemple de réalisation, chacune des régions de source 116 / drain 118 comporte une couche de TiN sur laquelle est formée une portion de tungstène. Différents métaux peuvent être utilisés pour former les régions 116, 118 afin de favoriser de faibles résistances de contact, comme par exemple : S, Bi, Sn, Pd, Ru, Cu, Ni, Ti, TiN, W, Au, etc. Ces matériaux peuvent aussi être modifiés ultérieurement (pour améliorer leur propriétés), par une étape de dopage par exemple.

Les dispositifs obtenus à l'issue de ce procédé correspondent aux dispositifs 100 représentés sur la figure 16.

Dans l'exemple de réalisation précédemment décrit, la couche de semi-conducteur 120 ne remplit pas complètement les espaces formés par la gravure des portions 138, et des portions diélectriques 126 sont réalisées dans les espaces restants après le dépôt de la couche de semi-conducteur 120.

Selon une première variante, il est possible de ne pas réaliser les portions diélectriques 126, la couche de semi-conducteur 120 remplissant dans ce cas, lors de son dépôt, les espaces restants formés par la gravure des portions 138. Dans ce cas, il est possible d'observer la formation d'air-gap, c'est-à-dire de creux ou d'espaces vides, dans les premières zones 122 de la couche de semi-conducteur 120. Néanmoins, ces air-gaps n'empêchent pas la continuité entre les premières zones 122 et les deuxièmes zones 124 de la couche de semi-conducteur 120.

Selon l'invention (qui est compatible avec la première variante ci-dessus, ladite première variante ne faisant pas partie de la présente invention mais utile pour sa compréhension) il est possible que la couche 112 formant le diélectrique de grille ne soit pas déposée juste avant la réalisation de la grille 110 comme précédemment décrit. Selon l'invention, cette couche est déposée dans les espaces formés par la gravure des portions 138 et dans les cavités 150, juste avant le dépôt de la couche de semi-conducteur 120. Dans ce cas, la couche 112 vient recouvrir les différentes parois sur lesquelles le matériau de la couche de semi-conducteur 120 est destiné à être déposé, homogénéisant ainsi les surfaces, et donc les interfaces, contre lesquelles la couche de semi-conducteur 120 est ensuite déposée. Selon une autre variante (qui est compatible avec la première variante décrite ci-dessus), il est possible que la couche 112 soit déposée lors de deux étapes différentes : tout d'abord juste avant la réalisation de la grille 110 comme précédemment décrit en lien avec la figure 8, puis dans les espaces formés par la gravure des portions 138 et dans les cavités 150, juste avant le dépôt de la couche de semi-conducteur 120. Dans ce cas, les parties de la couche 112 localisées à l'aplomb de la grille 110 sont plus épaisses que les autres parties de la couche 112 car ces parties cumulent les épaisseurs de matériau déposées au cours des deux étapes de dépôt.

Dans l'exemple de réalisation précédemment décrit, toutes les parois latérales des cavités 150 sont recouvertes par les deuxièmes zones 124 de la couche de semi-conducteur 120.

En variante, il est possible qu'une partie seulement de ces parois latérales soit recouverte par les deuxièmes zones 124.

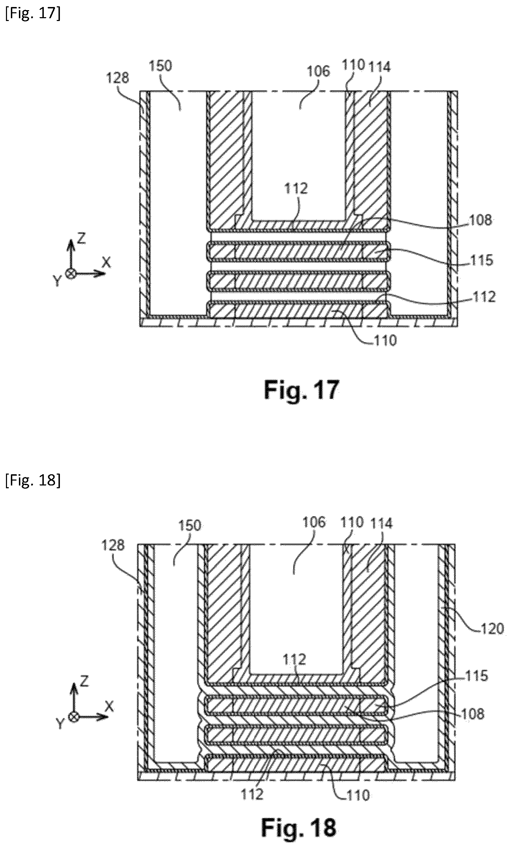

Les figures 17 à 20 représentent schématiquement une partie des étapes du procédé mis en œuvre combinant les deux variantes décrites ci-dessus.

Les étapes précédemment décrites en lien avec les figures 1 à 12 sont tout d'abord mises en œuvre.

Ensuite, contrairement au précédent exemple de réalisation dans lequel la couche de semi-conducteur 120 est déposée, la couche 112 formant les diélectriques de grille, comprenant avantageusement un matériau diélectrique high-K tel que du HfO₂, est déposée sur l'ensemble de la structure (voir figure 17). Des parties de cette couche 112 sont localisées dans les espaces en forme de tunnels précédemment formés, formant ainsi les diélectriques de grille, et d'autres parties de cette couche 112 recouvrent les parois des cavités 150.

La couche de semi-conducteur 120 est ensuite déposée sur l'ensemble de la structure, en recouvrant la couche 112 formant les diélectriques de grille (voir figure 18), de manière à remplir complètement les espaces restants en forme de tunnels. Dans la mesure où la couche de semi-conducteur 120 est déposée sur la couche 112 et donc sur un seul matériau, cette couche 112 dite « tampon » permet d'obtenir ensuite une couche 120 de matériau 2D qui est plus homogène et mieux contrôlée.

Sur la figure 18, la couche 112 de diélectrique ou de mémoire ferroélectrique est en contact avec un fond et des parois latérales de cavités 150. La couche de semi-conducteur 120 recouvre la couche de diélectrique ou de mémoire ferroélectrique au niveau du fond et desdites parois latérales des cavités.

Les cavités 150 ne sont alors pas complètement remplies par le dépôt de la couche 120 et de la couche 112 formant les diélectriques de grille.

Les régions de source 116 / drain 118 sont ensuite réalisées, par exemple en réalisant un premier dépôt (par exemple ALD) de TiN (désigné par la référence 154 sur la figure 19), puis en remplissant le reste de l'espace disponible par du tungstène (désigné par la référence 156 sur la figure 20). Dans l'exemple décrit ici, ce dépôt de tungstène achève également la réalisation de la grille de commande 110.

L'une des variantes ci-dessus peut être mise en œuvre sans que l'autre ne le soit. Par exemple, il est possible de déposer la couche 112 formant le diélectrique de grille dans les espaces formés par la gravure des portions 138, avant le dépôt de la couche de semi-conducteur 120, et que des espaces vides soient encore présents après le dépôt de la couche de semi-conducteur 120. Dans ce cas, les portions diélectriques 126 peuvent être réalisées comme précédemment décrit en lien avec les figures 14 et 15.

Dans l'exemple de réalisation représenté sur la figure 16, la grille de commande 110 est commune à plusieurs dispositifs 100, c'est-à-dire commande simultanément ces différents dispositifs, dont les régions 116, 118 sont isolées électriquement de celles des autres dispositifs 100 voisins par les portions du matériau diélectrique d'isolation 128. En variante, il est possible que les grilles 110 réalisées ne soient pas communes aux différents dispositifs 100 réalisés.

En outre, chacune des premières zones 122 de la couche de semi-conducteur 120 peut être entourée par une même grille de commande électrostatique 110, comme c'est le cas dans les exemples précédemment décrits, ou par une grille de commande électrostatique différente de celle entourant les autres premières zones 122 de la couche de semi-conducteur 120.

Dans les précédents exemples de réalisation, le dispositif microélectronique 100 réalisé correspond à un transistor MOSFET. Plus particulièrement, le transistor décrit est de type « GAA stacked nanosheet ».

Les étapes décrites ci-dessus pour réaliser les dispositifs 100 peuvent être répétées une deuxième fois lorsque les dispositifs 100 réalisés sont de type CFET, en modifiant alors la conductivité de la couche de semi-conducteur réalisée pour la seconde structure localisée sur la première structure. Différentes configurations sont envisageables : première structure dotée d'une couche de semi-conducteur 120 de type n sur laquelle une deuxième structure dotée d'une couche de semi-conducteur 120 de type p est réalisée, ou inversement.

Dans l'exemple de réalisation représenté sur la figure 16, chacune des régions de source et de drain 116, 118 est disposée dans une cavité comprenant des parois latérales formées par les espaceurs diélectriques 114, 115 et par un matériau diélectrique d'isolation 128. Dans cette configuration, les deuxièmes zones 124 de la couche de semi-conducteur 120 recouvrent les parois latérales et les parois de fond des cavités dans lesquelles sont disposées les régions de source et de drain 116, 118.

En alternative, il est possible que des régions de source et de drain soient communes à plusieurs dispositifs 100. Par exemple, il est possible que pour deux dispositifs 100 adjacents, le matériau diélectrique d'isolation 128 ne soit pas présent afin qu'une même région de source / drain, par exemple la région de source, soit couplée électriquement aux canaux de ces deux dispositifs 100 voisins.

Dans les exemples et variantes précédemment décrits, la couche 112 comporte un matériau diélectrique destiné à former les diélectriques de grille des dispositifs 100 réalisés qui correspondent à des transistors de type GAA à nanofils ou « nano-sheets » empilés, ou CFET. En variante, il est possible que la couche 112 comporte un matériau ferroélectrique tel que du HfO₂ ou HfZrO₂, cette couche 112 correspondant dans ce cas à une couche mémoire ferroélectrique. Les dispositifs 100 réalisés correspondent à des dispositifs microélectroniques ayant une fonction mémoire de type FeFET. Les différentes variantes de réalisation de la couche 112 précédemment décrites s'appliquent également à une couche 112 comportant un matériau ferroélectrique. En outre, lorsque la couche 112 comporte un matériau ferroélectrique, il est avantageux que la couche 112 soit déposée dans les espaces formés par la gravure des portions 138 et dans les cavités 150, juste avant le dépôt de la couche de semi-conducteur 120, ou déposée lors de deux étapes différentes comme précédemment décrit. Ainsi, la surface de matériau ferroélectrique formée par la couche 112 est plus importante que si elle était déposée uniquement juste avant la réalisation de la grille 110, ce qui réduit la variabilité de la mémoire en termes de performance.

Selon une autre réalisation possible, le ou les dispositifs 100 réalisés peuvent correspondre à des dispositifs mémoire par exemple de type 1T1C, 1T1R, 2T1C ou 2T1R. Dans ce cas, l'une des régions de contact 116, 118 comporte au moins un empilement mémoire 158, c'est-à-dire un empilement de matériaux dans lequel il est possible de réaliser une mémorisation d'information. Cet empilement mémoire 158 peut correspondre à un empilement de matériaux de type FeRAM incluant dans ce cas une couche de matériau ferroélectrique, ou OxRAM incluant dans ce une couche d'oxyde, ou CBRAM incluant dans ce cas une couche ionique, par exemple sous forme d'un empilement de type MIM (métal - isolant - métal).

Un exemple selon cette autre réalisation est représenté schématiquement sur la figure 21. L'empilement mémoire 158 est disposé au sein du ou des matériaux métalliques formant le reste de la région de contact 118. Une partie du ou des matériaux métalliques est interposée entre l'empilement mémoire 158 et les parties de la couche de semi-conducteur 120 localisées dans la cavité 150 dans laquelle la région de contact 118 est réalisée. Ainsi, l'empilement mémoire 158 se retrouve interposé entre une première portion conductrice 157 de la région de contact 118, reliant électriquement l'empilement mémoire 158 à la couche de semi-conducteur 120, et une deuxième portion conductrice 156 de la région de contact 118 formant un contact électrique de l'empilement mémoire 158.

## Revendications

1. Dispositif microélectronique (100) comprenant :
- un substrat (102) ;
- une couche de semi-conducteur (120) comprenant plusieurs premières zones (122) superposées les unes au-dessus des autres et formant un canal de conduction électrique du dispositif microélectronique (100) ;
- une grille de commande électrostatique (110) ;
- une couche (112) de diélectrique de grille ou une couche (112) mémoire ferroélectrique, telles que des parties de la couche (112) de diélectrique de grille ou de la couche (112) mémoire ferroélectrique soient chacune disposées entre une partie (106, 108) de la grille de commande électrostatique (110) et l'une des premières zones (122) de la couche de semi-conducteur (120) ;
- des espaceurs diélectriques (114) disposés contre des flancs de la grille de commande électrostatique (110) ;
- des régions de source (116) / drain (118) couplées électriquement aux premières zones (122) de la couche de semi-conducteur (120) par des deuxièmes zones (124) de la couche de semi-conducteur (120), les deuxièmes zones (124) de la couche de semi-conducteur (120) s'étendant entre les régions de source (116) / drain (118) et les espaceurs diélectriques (114) ;
et dans lequel les deuxièmes zones (124) de la couche de semi-conducteur (120) forment, avec les premières zones (122), une couche continue,
**caractérise en ce que**
les deuxièmes zones (124) de la couche de semi-conducteur (120) sont disposées directement contre et en contact avec la couche (112) de diélectrique ou de mémoire ferroélectrique.

2. Dispositif microélectronique (100) selon la revendication 1, dans lequel la couche de semi-conducteur (120) comporte un matériau bidimensionnel.

3. Dispositif microélectronique (100) selon l'une des revendications précédentes, dans lequel :
- chacune des régions de source (116) / drain (118) est disposée dans une cavité (150) comprenant des parois latérales formées au moins par les espaceurs diélectriques (114) et par un matériau diélectrique d'isolation (128) au moins ou par les espaceurs diélectriques (114) et par des espaceurs d'un dispositif microélectronique voisin ;
- la couche (112) de diélectrique ou de mémoire ferroélectrique étant en contact avec un fond et lesdites parois latérales des cavités (150) dans lesquelles sont disposées les régions de source (116) / drain (118)
- les deuxièmes zones (124) de la couche de semi-conducteur (120) recouvrent les parois des cavités, la couche (112) de diélectrique ou de mémoire ferroélectrique au niveau du fond et desdites parois latérales des cavités (150) dans lesquelles sont disposées les régions de source (116) / drain (118).

4. Dispositif microélectronique (100) selon l'une des revendications précédentes, dans lequel chacune des premières zones (122) de la couche de semi-conducteur (120) est entourée par une même grille de commande électrostatique (110) ou par une grille de commande électrostatique (110) différente de celle entourant les autres premières zones (122) de la couche de semi-conducteur (120).

5. Dispositif microélectronique (100) selon l'une des revendications précédentes, comportant en outre une ou plusieurs portions diélectriques (126) chacune disposée entre deux premières zones (122) de la couche de semi-conducteur (120) et telles que chacune des portions diélectriques (126) soit entourée par l'une des premières zones (122) de la couche de semi-conducteur (120).

6. Dispositif microélectronique (100) selon l'une des revendications précédentes, comportant en outre des espaceurs diélectriques internes (115) disposés contre des flancs d'une ou plusieurs parties (108) de la grille de commande électrostatique (110).

7. Composant microélectronique (1000) comportant plusieurs dispositifs microélectroniques (100) selon l'une des revendications précédentes, et dans lequel :
- les grilles de commande électrostatiques (110) de plusieurs des dispositifs microélectroniques (100) sont communes et formées intégralement par les mêmes portions de matériau, et/ou
- l'une des régions de source (116) / drain (118) est commune à deux des dispositifs microélectroniques (100) voisins.

8. Procédé de réalisation d'un dispositif microélectronique (100) selon l'une des revendications 1 à 7, comprenant au moins :
a) réalisation, sur un substrat (102), d'au moins un empilement (134) alterné de portions d'un premier matériau (136) et de portions d'un deuxième matériau (138), les premier et deuxième matériaux étant aptes à être gravés sélectivement l'un vis-à-vis de l'autre, puis
b) réalisation d'une grille temporaire (142) recouvrant une partie d'une face supérieure et de faces latérales de l'empilement (134), puis
c) réalisation d'espaceurs diélectriques (114) contre des flancs de la grille temporaire (142), puis
d) gravure de parties de l'empilement (134) non recouvertes par la grille temporaire (142) et les espaceurs diélectriques (114), puis
e) gravure de la grille temporaire (142), puis
f) gravure des portions du premier matériau (136) sélectivement vis-à-vis des portions du deuxième matériau (138), puis
g) réalisation d'au moins une partie d'une grille de commande électrostatique (110) dans un espace formé par la gravure de la grille temporaire (142), telle que les espaceurs diélectriques (114) soient disposés contre les flancs de la grille de commande électrostatique (110), puis
h) gravure des portions du deuxième matériau (138), puis
i) réalisation d'une couche de semi-conducteur (120) comprenant plusieurs premières zones (122) configurées pour former un canal de conduction électrique du dispositif microélectronique (100) et disposées contre la grille (110) dans des emplacements formés par la gravure des portions du deuxième matériau (138), la couche de semi-conducteur (120) se prolongeant, sans discontinuité avec les premières zones (122), en formant des deuxièmes zones (124) couvrant au moins une partie des flancs des espaceurs diélectriques (114) et qui ne sont pas disposées directement contre la grille de commande électrostatique (110), puis
j) réalisation, sur le substrat (102), de régions de source (116) / drain (118) couplées électriquement aux premières zones (122) de la couche de semi-conducteur (120) par les deuxièmes zones (124) de la couche de semi-conducteur (120), et telles que les deuxièmes zones (124) de la couche de semi-conducteur (120) s'étendent entre chacune des régions de source (116) / drain (118) et les espaceurs diélectriques (114),
et comportant en outre une étape de dépôt d'une couche (112) de diélectrique de grille ou d'une couche (112) mémoire ferroélectrique, la couche de diélectrique de grille ou mémoire ferroélectrique étant mise en œuvre -entre les étapes h) et i), dans les emplacements formés par la gravure des portions du deuxième matériau (138), la couche de semi-conducteur (120) étant réalisée ensuite en recouvrant la couche (112) de diélectrique de grille ou la couche (112) mémoire ferroélectrique, les deuxièmes zones (124) de la couche de semi-conducteur (120) étant disposées directement contre et en contact avec la couche (112) de diélectrique ou de mémoire ferroélectrique et formant, avec les premières zones (122), une couche continue.

9. Procédé selon la revendication 8, comportant en outre, entre les étapes d) et e), un dépôt d'un matériau diélectrique d'isolation (128) autour des espaceurs diélectriques (114), puis une gravure de cavités (150) dans le matériau diélectrique d'isolation (128) telle que chacune des cavités (150) comprenne au moins une paroi latérale formée par l'un des espaceurs diélectriques (114), et dans lequel :
- l'étape i) est mise en œuvre telle que les deuxièmes zones (124) de la couche de semi-conducteur (120) recouvrent au moins une partie des parois latérales des cavités (150), et
- l'étape j) est mise en œuvre telle que chacune des régions de source (116) / drain (118) soit disposée dans une des cavités (150).

10. Procédé selon l'une des revendications 8 ou 9, dans lequel l'étape i) est mise en œuvre telle que les premières zones (122) de la couche de semi-conducteur (120) recouvrent des parois des emplacements formés par la gravure des portions du deuxième matériau (138), et le procédé comporte en outre, entre les étapes i) et j), une réalisation de portions diélectriques (126) dans des espaces restants des emplacements et telles que chacune des portions diélectriques (126) soient entourées par les premières zones (122) de la couche de semi-conducteur (120).

11. Procédé selon l'une des revendications 8 ou 9, dans lequel l'étape i) est mise en œuvre telle que les premières zones (122) de la couche de semi-conducteur (120) remplissent complètement les emplacements formés par la gravure des portions du deuxième matériau (138).

12. Procédé selon l'une des revendications 8 à 11, comportant en outre, entre les étapes d) et e), une gravure de parties des portions du premier matériau (136) disposées à l'aplomb des espaceurs diélectriques (114), et une réalisation d'espaceurs diélectriques internes (115) à la place des parties gravées des portions du premier matériau (136).

13. Procédé selon l'une des revendications 8 à 12, dans lequel la réalisation de la couche de semi-conducteur (120) comporte la mise en œuvre d'un dépôt d'un matériau semi-conducteur par MOCVD ou CVD ou ALD.

14. Procédé selon l'une des revendications 8 à 13, dans lequel la couche (112) de diélectrique de grille ou la couche (112) mémoire ferroélectrique est réalisée, après l'étape h) et avant l'étape i), par dépôt sur l'ensemble d'une structure en cours de réalisation, la couche de semi-conducteur (120) étant réalisée ensuite à l'étape i) sur l'ensemble de la structure en recouvrant la couche (112) de diélectrique de grille ou la couche (112) mémoire ferroélectrique.

15. Procédé selon l'une des revendications 8 à 14, la couche de semi-conducteur (120) est formée à l'étape i) uniquement sur la couche (112) de diélectrique de grille ou la couche (112) mémoire ferroélectrique.

## Patentansprüche

1. Mikroelektronische Vorrichtung (100), umfassend:
- ein Substrat (102);
- eine Halbleiterschicht (120), die mehrere übereinanderliegende erste Bereiche (122) umfasst und einen elektrischen Leitungskanal der mikroelektronischen Vorrichtung (100) bildet;
- ein elektrostatisches Steuergate (110);
- eine Gatedielektrikumschicht (112) oder eine ferroelektrische Speicherschicht (112) derart, dass Teile der Gatedielektrikumschicht (112) oder der ferroelektrischen Speicherschicht (112) jeweils zwischen einem Teil (106, 108) des elektrostatischen Steuergates (110) und einem der ersten Bereiche (122) der Halbleiterschicht (120) angeordnet sind;
- dielektrische Abstandshalter (114), die an Flanken des elektrostatischen Steuergates (110) angeordnet sind;
- Source- (116)/Drain- (118) Bereiche, die durch zweite Bereiche (124) der Halbleiterschicht (120) elektrisch mit den ersten Bereichen (122) der Halbleiterschicht (120) gekoppelt sind, wobei sich die zweiten Bereiche (124) der Halbleiterschicht (120) zwischen den Source- (116)/Drain- (118) Bereichen und den dielektrischen Abstandshaltern (114) erstrecken;
und wobei die zweiten Bereiche (124) der Halbleiterschicht (120) zusammen mit den ersten Bereichen (122) eine durchgehende Schicht bilden,
**dadurch gekennzeichnet, dass**
die zweiten Bereiche (124) der Halbleiterschicht (120) direkt an und in Kontakt mit der Dielektrikum- oder der ferroelektrischen Speicherschicht (112) angeordnet sind.

2. Mikroelektronische Vorrichtung (100) nach Anspruch 1, wobei die Halbleiterschicht (120) ein zweidimensionales Material umfasst.

3. Mikroelektronische Vorrichtung (100) nach einem der vorstehenden Ansprüche, wobei:
- jeder der Source- (116)/Drain- (118) Bereiche in einem Hohlraum (150) angeordnet ist, der Seitenwände umfasst, die mindestens von den dielektrischen Abstandshaltern (114) und von mindestens einem dielektrischen Isolationsmaterial (128) oder von den dielektrischen Abstandshaltern (114) und von Abstandshaltern einer benachbarten mikroelektronischen Vorrichtung gebildet werden;
- die Dielektrikum- oder die ferroelektrische Speicherschicht (112) mit einem Boden und den Seitenwänden der Hohlräume (150), in denen die Source-(116)/Drain- (118) Bereiche angeordnet sind, in Kontakt stehen,
- die zweiten Bereiche (124) der Halbleiterschicht (120) die Wände der Hohlräume, die Dielektrikum- oder die ferroelektrische Speicherschicht (112) im Bereich des Bodens und der Seitenwände der Hohlräume (150), in denen die Source- (116)/Drain- (118) Bereiche angeordnet sind, bedecken.

4. Mikroelektronische Vorrichtung (100) nach einem der vorstehenden Ansprüche, wobei jeder der ersten Bereiche (122) der Halbleiterschicht (120) von demselben elektrostatischen Steuergate (110) oder von einem elektrostatischen Steuergate (110) umgeben ist, das sich von dem unterscheidet, welches die anderen ersten Bereiche (122) der Halbleiterschicht (120) umgibt.

5. Mikroelektronische Vorrichtung (100) nach einem der vorstehenden Ansprüche, die weiter einen oder mehrere dielektrische Abschnitte (126) umfasst, die jeweils zwischen zwei ersten Bereichen (122) der Halbleiterschicht (120) und derart angeordnet sind, dass jeder der dielektrischen Abschnitte (126) von einem der ersten Bereiche (122) der Halbleiterschicht (120) umgeben ist.

6. Mikroelektronische Vorrichtung (100) nach einem der vorstehenden Ansprüche, die weiter innere dielektrische Abstandshalter (115) umfasst, die an Flanken eines oder mehrerer Teile (108) des elektrostatischen Steuergates (110) angeordnet sind.

7. Mikroelektronische Komponente (1000), die mehrere mikroelektronische Vorrichtungen (100) nach einem der vorstehenden Ansprüche umfasst, und wobei:
- die elektrostatischen Steuergates (110) mehrerer der mikroelektronischen Vorrichtungen (100) gemein sind und einstückig von denselben Materialabschnitten gebildet werden, und/oder
- einer der Source- (116)/Drain- (118) Bereiche zweien der benachbarten mikroelektronischen Vorrichtungen (100) gemein ist.

8. Verfahren zur Herstellung einer mikroelektronischen Vorrichtung (100) nach einem der Ansprüche 1 bis 7, das mindestens umfasst:
a) Herstellen, auf einem Substrat (102), mindestens eines abwechselnden Stapels (134) aus Abschnitten eines ersten Materials (136) und Abschnitten eines zweiten Materials (138), wobei das erste und das zweite Material selektiv in Bezug zueinander geätzt werden können, danach
b) Herstellen eines temporären Gates (142), das einen Teil einer oberen Fläche und von Seitenflächen des Stapels (134) bedeckt, danach
c) Herstellen von dielektrischen Abstandshaltern (114) an Flanken des temporären Gates (142), danach
d) Ätzen von Teilen des Stapels (134), die nicht von dem temporären Gate (142) und den dielektrischen Abstandshaltern (114) bedeckt sind, danach
e) Ätzen des temporären Gates (142), danach
f) selektives Ätzen der Abschnitte des ersten Materials (136) in Bezug auf die Abschnitte des zweiten Materials (138), danach
g) Herstellen mindestens eines Teils eines elektrostatischen Steuergates (110) in einem Raum, der durch das Ätzen des temporären Gates (142) gebildet wurde, derart, dass die dielektrischen Abstandshalter (114) an den Flanken des elektrostatischen Steuergates (110) angeordnet sind, danach
h) Ätzen der Abschnitte des zweiten Materials (138), danach
i) Herstellen einer Halbleiterschicht (120), die mehrere erste Bereiche (122) umfasst, die so ausgestaltet sind, dass sie einen elektrischen Leitungskanal der mikroelektronischen Vorrichtung (100) bilden und an Stellen, die durch das Ätzen der Abschnitte des zweiten Materials (138) gebildet wurden, an dem Gate (110) angeordnet sind, wobei sich die Halbleiterschicht (120) ohne Unterbrechung mit den ersten Bereichen (122) fortsetzt und dabei zweite Bereiche (124) bildet, die mindestens einen Teil der Flanken der dielektrischen Abstandshalter (114) bedecken und die nicht direkt an dem elektrostatischen Steuergate (110) angeordnet sind, danach
j) Herstellen, auf dem Substrat (102), von Source- (116)/Drain- (118) Bereichen, die durch die zweiten Bereiche (124) der Halbleiterschicht (120) elektrisch mit den ersten Bereichen (122) der Halbleiterschicht (120) gekoppelt sind, und derart, dass sich die zweiten Bereiche (124) der Halbleiterschicht (120) zwischen jedem der Source- (116)/Drain- (118) Bereiche und den dielektrischen Abstandshaltern (114) erstrecken, und weiter einen Schritt des Abscheidens einer Gatedielektrikumschicht (112) oder einer ferroelektrischen Speicherschicht (112) umfassend, wobei die Gatedielektrikum- oder die ferroelektrische Speicherschicht eingesetzt wird
zwischen den Schritten h) und i) an den Stellen, die durch das Ätzen der Abschnitte des zweiten Materials (138) gebildet wurden, wobei die Halbleiterschicht (120) anschließend durch Bedecken der Gatedielektrikumschicht (112) oder der ferroelektrischen Speicherschicht (112) hergestellt wird, wobei die zweiten Bereiche (124) der Halbleiterschicht (120) direkt an und in Kontakt mit der Dielektrikum- oder der ferroelektrischen Speicherschicht (112) angeordnet sind und mit den ersten Bereichen (122) eine durchgehende Schicht bilden.

9. Verfahren nach Anspruch 8, das zwischen den Schritten d) und e) weiter ein Abscheiden eines dielektrischen Isolationsmaterials (128) um die dielektrischen Abstandshalter (114) herum, und danach ein Ätzen von Hohlräumen (150) in dem dielektrischen Isolationsmaterial (128) derart umfasst, dass jeder der Hohlräume (150) mindestens eine Seitenwand umfasst, die von einem der dielektrischen Abstandshalter (114) gebildet wird, und wobei:
- Schritt i) derart ausgeführt wird, dass die zweiten Bereiche (124) der Halbleiterschicht (120) mindestens einen Teil der Seitenwände der Hohlräume (150) bedecken, und - Schritt j) derart ausgeführt wird, dass jeder der Source-(116)/Drain- (118) Bereiche in einem der Hohlräume (150) angeordnet ist.

10. Verfahren nach einem der Ansprüche 8 oder 9, wobei Schritt i) derart ausgeführt wird, dass die ersten Bereiche (122) der Halbleiterschicht (120) Wände der Stellen, die durch das Ätzen der Abschnitte des zweiten Materials (138) gebildet wurden, bedecken, und das Verfahren zwischen den Schritten i) und j) weiter ein Herstellen von dielektrischen Abschnitten (126) in verbleibenden Räumen der Stellen und derart umfasst, dass jeder der dielektrischen Abschnitte (126) von den ersten Bereichen (122) der Halbleiterschicht (120) umgeben ist.

11. Verfahren nach einem der Ansprüche 8 oder 9, wobei Schritt i) derart ausgeführt wird, dass die ersten Bereiche (122) der Halbleiterschicht (120) die Stellen, die durch das Ätzen der Abschnitte des zweiten Materials (138) gebildet wurden, vollständig füllen.

12. Verfahren nach einem der Ansprüche 8 bis 11, das zwischen den Schritten d) und e) weiter ein Ätzen von Teilen der Abschnitte des ersten Materials (136), die senkrecht zu den dielektrischen Abstandshaltern (114) angeordnet sind, und ein Herstellen von inneren dielektrischen Abstandshaltern (115) anstelle der geätzten Teile der Abschnitte des ersten Materials (136) umfasst.

13. Verfahren nach einem der Ansprüche 8 bis 12, wobei das Herstellen der Halbleiterschicht (120) das Anbringen einer Abscheidung eines Halbleitermaterials durch MOCVD oder CVD oder ALD umfasst.

14. Verfahren nach einem der Ansprüche 8 bis 13, wobei die Gatedielektrikumschicht (112) oder die ferroelektrische Speicherschicht (112) nach Schritt h) und vor Schritt i) durch Abscheiden auf der Gesamtheit einer in Herstellung befindlichen Struktur hergestellt wird, wobei die Halbleiterschicht (120) anschließend in Schritt i) auf der Gesamtheit der Struktur durch Bedecken der Gatedielektrikumschicht (112) oder der ferroelektrischen Speicherschicht (112) hergestellt wird.

15. Verfahren nach einem der Ansprüche 8 bis 14, wobei die Halbleiterschicht (120) in Schritt i) nur auf der Gatedielektrikumschicht (112) oder der ferroelektrischen Speicherschicht (112) gebildet wird.

## Claims

1. A microelectronic device (100) comprising:
- a substrate (102);
- a semiconductor layer (120) comprising several first areas (122) superposed on top of one another and forming an electrical conduction channel of the microelectronic device (100);
- an electrostatic control gate (110);
- a gate dielectric layer (112) or a ferroelectric memory layer (112), such that parts of the gate dielectric layer (112) or of the ferroelectric memory layer (112) are each arranged between a part (106, 108) of the electrostatic control gate (110) and one amongst the first areas (122) of the semiconductor layer (120);
- dielectric spacers (114) arranged against sidewalls of the electrostatic control gate (110);
- source (116) / drain (118) regions electrically coupled to the first areas (122) of the semiconductor layer (120) by second areas (124) of the semiconductor layer (120), the second areas (124) of the semiconductor layer (120) extending between the source (116) / drain (118) regions and the dielectric spacers (114);
and wherein the second areas (124) of the semiconductor layer (120) form a continuous layer with the first areas (122), **characterized in that** the second areas (124) are arranged directly against and in contact with the dielectric or ferroelectric memory layer (112).

2. The microelectronic device (100) according to claim 1, wherein the semiconductor layer (120) includes a two-dimensional material.

3. The microelectronic device (100) according to one of the preceding claims, wherein:
- each of the source (116) / drain (118) regions is arranged in a cavity (150) comprising lateral walls formed at least by the dielectric spacers (114) and at least by an insulating dielectric material (128) or by the dielectric spacers (114) and by spacers of a neighbouring microelectronic device;
- the dielectric or ferroelectric memory layer (112) being in contact with a bottom and said lateral walls of the cavities (150) in which the source (116) / drain (118) regions are arranged
- the second areas (124) of the semiconductor layer (120) cover the walls of the cavities, the dielectric or ferroelectric memory layer (112) at the bottom and said lateral walls of the cavities (150) in which the source (116) / drain (118) regions are arranged.

4. The microelectronic device (100) according to one of the preceding claims, wherein each of the first areas (122) of the semiconductor layer (120) is surrounded by the same electrostatic control gate (110) or by an electrostatic control gate (110) different from that surrounding the other first areas (122) of the semiconductor layer (120).

5. The microelectronic device (100) according to one of the preceding claims, further including one or more dielectric portion(s) (126) each arranged between two first areas (122) of the semiconductor layer (120) and such that each of the dielectric portions (126) is surrounded by one amongst the first areas (122) of the semiconductor layer (120).

6. The microelectronic device (100) according to one of the preceding claims, further including inner dielectric spacers (115) arranged against sidewalls of one or more part(s) (108) of the electrostatic control gate (110).

7. A microelectronic component (1000) including several microelectronic devices (100) according to one of the preceding claims, and wherein:
- the electrostatic control gates (110) of several ones among the microelectronic devices (100) are common and formed by the same material portions, and/or
- one amongst the source (116) / drain (118) regions is common to two neighbouring ones among the microelectronic devices (100).

8. A method for making a microelectronic device (100) comprising at least:
a) making, over a substrate (102), at least one alternating stack (134) of portions of a first material (136) and of portions of a second material (138), the first and second materials can be etched selectively with respect to one another, then
b) making a temporary gate (142) covering a part of an upper face and of lateral faces of the stack (134), then
c) making dielectric spacers (114) against sidewalls of the temporary gate (142), then
d) etching parts of the stack (134) that are not covered with the temporary gate (142) and the dielectric spacers (114), then
e) etching the temporary gate (142), then
f) etching the portions of the first material (136) selectively with respect to the portions of the second material (138), then
g) making at least one part of an electrostatic control gate (110) in a space formed by etching of the temporary gate (142), such that the dielectric spacers (114) are arranged against the sidewalls of the electrostatic control gate (110), then
h) etching the portions of the second material (138), then
i) making a semiconductor layer (120) comprising several first areas (122) configured to form an electrical conduction channel of the microelectronic device (100) and arranged against the gate (110) in locations formed by etching of the portions of the second material (138), the semiconductor layer (120) extending, with no discontinuity with the first areas (122), while forming second areas (124) covering at least one part of the sidewalls of the dielectric spacers (114) and which are not directly arranged against the electrostatic control gate (110), then
j) making, over the substrate (102), source (116) / drain (118) regions electrically coupled to the first areas (122) of the semiconductor layer (120) by the second areas (124) of the semiconductor layer (120), and such that the second areas (124) of the semiconductor layer (120) extend between each of the source (116) / drain (118) regions and the dielectric spacers (114), and further including a step of depositing a gate dielectric layer (112) or a ferroelectric memory layer (112), the gate dielectric or ferroelectric memory layer being implemented:
- between steps h) and i), in the locations formed by etching of the portions of the second material (138), the semiconductor layer (120) being made afterwards by covering the gate dielectric layer (112) or the ferroelectric memory layer (112), the second areas (124) are arranged directly against and in contact with the dielectric or ferroelectric memory layer (112) and forming a continuous layer with the first areas (122).

9. The method according to claim 8, further including, between steps d) and e), depositing an insulating dielectric material (128) around the dielectric spacers (114), then etching cavities (150) in the insulating dielectric material (128) such that each of the cavities (150) comprises at least one lateral wall formed by one of the dielectric spacers (114), and wherein:
- step i) is implemented such that the second areas (124) of the semiconductor layer (120) cover at least one part of the lateral walls of the cavities (150), and
- step j) is implemented such that each of the source (116) / drain (118) regions is arranged in one amongst the cavities (150).

10. The method according to one of claims 8 or 9, wherein step i) is implemented such that the first areas (122) of the semiconductor layer (120) cover walls of the locations formed by etching of the portions of the second material (138), and the method further includes, between steps i) and j), making dielectric portions (126) in remaining spaces of the locations and such that each of the dielectric portions (126) is surrounded by the first areas (122) of the semiconductor layer (120).

11. The method according to one of claims 8 or 9, wherein step i) is implemented such that the first areas (122) of the semiconductor layer (120) completely fill the locations formed by etching of the portions of the second material (138).

12. The method according to one of claims 8 to 11, further including, between steps d) and e), etching parts of the portions of the first material (136) arranged directly above the dielectric spacers (114), and making inner dielectric spacers (115) instead of the etched parts of the portions of the first material (136).

13. The method according to one of claims 8 to 12, wherein making of the semiconductor layer (120) includes the implementation of a deposition of a semiconductor material by MOCVD or CVD or ALD.

14. The method according to one of claims 8 to 13, wherein the gate dielectric layer (112) or the ferroelectric memory layer (112) is made, after step h) and before step i), by deposition over the entirety of a structure being made, the semiconductor layer (120) being made afterwards in step i) over the entirety of the structure by covering the gate dielectric layer (112) or the ferroelectric memory layer (112).

15. The method according to one of claims 8 to 14, the semiconductor layer (120) is formed in step i) only over the gate dielectric layer (112) or the ferroelectric memory layer (112).
